# EUROPEAN PATENT APPLICATION

(11) **EP 4 436 329 A1**
(43) Date of publication of application: **25.09.2024**
(21) Application number: 24150208.7
(22) Date of filing: 03.01.2024
(51) Int. Cl.: H10B 12/00

(54) **INTEGRATED CIRCUIT DEVICE**

(30) Priority: 24.03.2023 KR 20230038972; 07.04.2023 KR 20230046197
(71) Applicant: Samsung Electronics Co., Ltd., Suwon-si, Gyeonggi-do 16677 (KR)
(72) Inventor: PARK, Chanhoon, 16677 Suwon-si (KR); KIM, Jongkyu, 16677 Suwon-si (KR); KIM, Seunghoon, 16677 Suwon-si (KR); PARK, Sohyun, 16677 Suwon-si (KR); LEE, Woohyun, 16677 Suwon-si (KR)
(74) Representative: Marks & Clerk LLP

(57) **Abstract**

An integrated circuit device includes a substrate having an active area, a plurality of bit line structures on the substrate, the plurality of bit line structures including insulating spacers on sidewalls thereof, a buried contact between the plurality of bit line structures and electrically connected to the active area, an insulation capping pattern on a bit line structure of the plurality of bit line structures, and a landing pad electrically connected to the buried contact, the landing pad arranged to vertically overlap the bit line structure on the insulation capping pattern, wherein an uppermost surface of the landing pad is higher than an uppermost surface of the insulation capping pattern, relative to the substrate.

## Description

### FIELD

The inventive concept relates to an integrated circuit device. More particularly, the inventive concept relates to an integrated circuit device including a capacitor.

### BACKGROUND

As semiconductor memory devices become more highly integrated, individual circuit patterns have become finer in order to implement more semiconductor memory devices in the same area. In other words, as the degree of integration of semiconductor devices increases, the design rules for components of the semiconductor devices decrease.

In highly scaled semiconductor memory devices, the process of forming capacitors may become increasingly complicated and difficult. In miniaturized semiconductor devices, securing the desired capacitance may reach limits with respect to some conventional capacitor structures.

### SUMMARY

The inventive concept provides an integrated circuit device including a capacitor with improved capacitance.

The inventive concept provides an integrated circuit device including a capacitor with improved performance and reliability.

In addition, the issues to be solved by the technical idea of the inventive concept are not limited to those mentioned above, and other issues may be clearly understood by those of ordinary skill in the art from the following descriptions.

Provided is an integrated circuit device as follows.

According to an aspect of the inventive concept, there is provided an integrated circuit device including a substrate having an active area, a plurality of bit line structures on the substrate, where a bit line structure of the plurality of bit line structures includes an insulating spacer on a sidewall thereof, a buried contact between the plurality of bit line structures, and electrically connected to the active area, an insulation capping pattern on the bit line structure, and a landing pad electrically connected to the buried contact, the landing pad arranged to vertically overlap the bit line structure on the insulation capping pattern, wherein an uppermost surface of the landing pad is higher than an uppermost surface of the insulation capping pattern relative to the substrate.

According to another aspect of the inventive concept, there is provided an integrated circuit device including a substrate including a cell area and a peripheral area, a plurality of bit line structures on the cell area, where a bit line structure of the plurality of bit line structures includes an insulating spacer on a sidewall thereof, a buried contact between the plurality of bit line structures, an insulation capping pattern on the bit line structure, a landing pad electrically connected to the buried contact, the landing pad arranged to vertically overlap the bit line structure on the insulation capping pattern, and a core structure on the peripheral area, and including a barrier metal layer on sidewalls thereof, wherein an uppermost surface of the core structure is substantially coplanar with an uppermost surface of the landing pad, and wherein the uppermost surface of the landing pad is higher than an uppermost surface of the insulation capping pattern relative to the substrate.

According to another aspect of the inventive concept, there is provided an integrated circuit device including a substrate having an active area defined by an element separation area, a pair of bit line structures on the substrate, and including an insulating spacer on a sidewall of a bit line structure of the pair of bit line structures, a buried contact between the pair of bit line structures, and electrically connected to the active area, an insulation capping pattern on the bit line structure, a landing pad electrically connected to the buried contact, the landing pad arranged to vertically overlap the bit line structure on the insulation capping pattern, and a capacitor structure on the landing pad, and including a capacitor lower electrode electrically connected to the landing pad, wherein an uppermost surface of the landing pad is higher than an uppermost surface of the insulation capping pattern relative to the substrate.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a plan view of a schematic configuration of an integrated circuit device, according to an embodiment;
FIG. 2 is a planar layout of major components of cell areas of an integrated circuit device, according to an embodiment;
FIGS. 3A and 3B are cross-sectional views of main components of an integrated circuit device, according to embodiments;
FIGS. 4A, 5A, 6A, 7A, 8A, 9A, 10A, 11A, and 12A are cross-sectional views taken along positions corresponding to line A-A' in FIG. 2, and FIGS. 4B, 5B, 6B, 7B, 8B, 9B, 10B, 11B, and 12B are cross-sectional views taken along positions corresponding to line B-B' in FIG. 2, which are cross-sectional views illustrating a manufacturing method of an integrated circuit device according to a process sequence, according to embodiments; and
FIG. 13 is a configuration diagram of a system including an integrated circuit device according to an embodiment.

### DETAILED DESCRIPTION OF EMBODIMENTS

Hereinafter, embodiments of the inventive concept are described in detail with reference to accompanying diagrams. Identical reference numerals are used for the same constituent devices in the drawings, and duplicate descriptions thereof are omitted. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items.

Because various changes can be applied to the embodiments and the inventive concept may have various embodiments, particular embodiments are illustrated in the diagrams and described in detail. However, this is not intended to limit the inventive concept to particular modes of practice, and it is to be appreciated that all changes, equivalents, and substitutes, which do not depart from the technical scope of the inventive concept, are encompassed in the inventive concept. In the description of the embodiments, certain detailed explanations of the related art are omitted when it is deemed that they may unnecessarily obscure the essence of the embodiments.

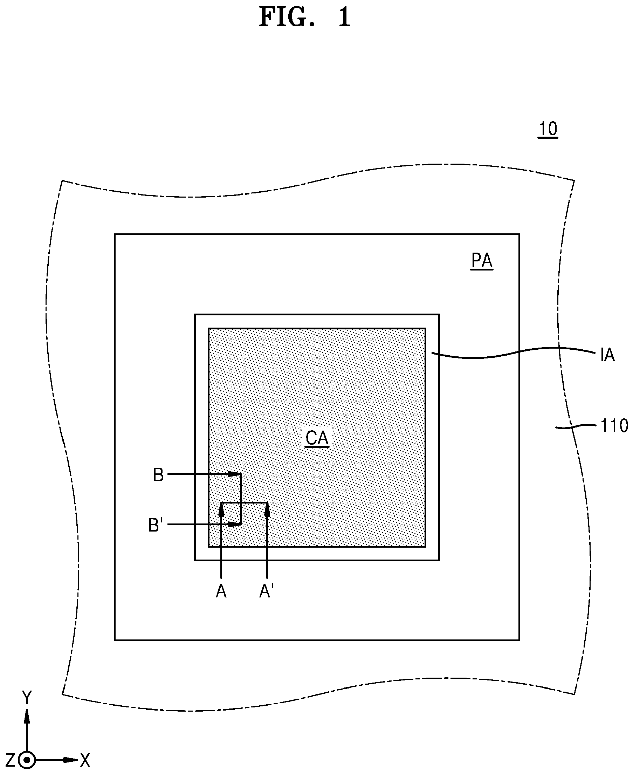

FIG. 1 is a plan view of a schematic configuration of an integrated circuit device 10, according to an embodiment.

Referring to FIG. 1, the integrated circuit device 10 may include a cell area CA, a core/periphery area (also referred to as a peripheral area) PA surrounding the cell area CA, and a substrate 110 including an interface area IA arranged between the cell area CA and the core/periphery area PA. The term "surrounding" or "covering" as may be used herein may not require completely surrounding or covering the described elements or layers, but may, for example, refer to partially surrounding or covering the described elements or layers. The peripheral area PA may include a core structure having a barrier metal layer on sidewalls thereof. An uppermost surface of the core structure is substantially coplanar with an uppermost surface of a landing pad LP as described hereinafter.

The substrate 110 may include a wafer including silicon (Si). Alternatively, the substrate 110 may include a wafer including a semiconductor element, such as germanium (Ge), or a compound semiconductor, such as silicon carbide (SiC), gallium arsenide (GaAs), indium arsenide (InAs), and indium phosphide (InP). On the other hand, the substrate 110 may have a silicon on insulator (SOI) structure. In addition, the substrate 110 may include a conductive area, for example, a well doped with impurities, or a structure doped with impurities.

In some embodiments, the cell area CA may include a memory cell area of the integrated circuit device 10. The cell area CA may constitute a memory cell area of a volatile memory element, or a memory cell area of a non-volatile memory element. The memory cell area may include memory cells, such as dynamic random access memory (RAM) (DRAM), magnetic RAM (MRAM), static RAM (SRAM), phase change RAM (PRAM), resistance RAM (RRAM), and ferroelectric RAM (FRAM). The cell area CA may include a unit memory cell including a transistor and a capacitor, or a unit memory cell including a switching element and a variable resistor.

In the core/periphery area PA, core circuits and periphery or peripheral circuits that may be used for driving memory cells in the cell area CA may be arranged.

In the interface area IA, a plurality of wiring lines arranged for an electrical connection of the cell area CA to the core/periphery area PA, and a structure for insulation between the cell area CA and the core/periphery area PA may be arranged.

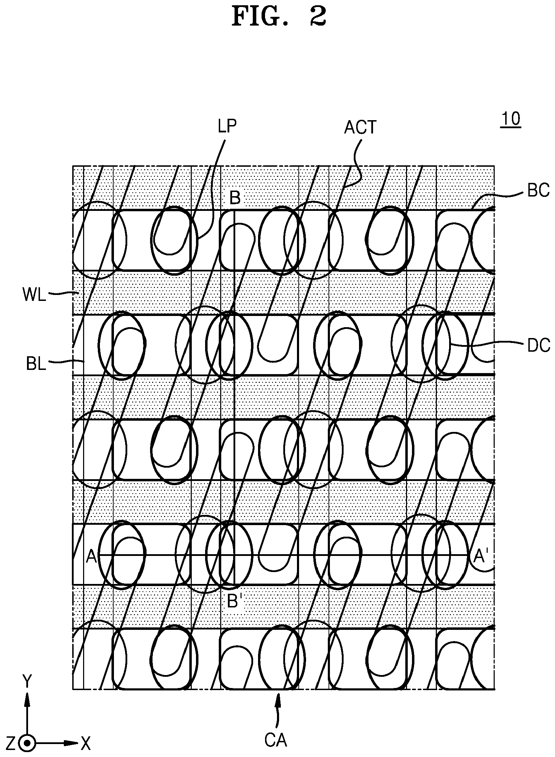

FIG. 2 is a planar layout or plan view of main components of the cell areas CA of the integrated circuit device 10, according to an embodiment.

Referring to FIG. 2, the integrated circuit device 10 may include a plurality of active areas ACT arranged to have a long axis in a diagonal direction with respect to a first horizontal direction (X direction) and a second horizontal direction (Y direction).

A plurality of word lines WL may extend in parallel with each other in the first horizontal direction (X direction) across the plurality of active areas ACT (also referred to herein as active areas 118). On the plurality of word lines WL, a plurality of bit lines BL may extend in parallel with each other in the second horizontal direction (Y direction) crossing the first horizontal direction (X direction).

The plurality of bit lines BL may be respectively connected to the plurality of active areas ACT via direct contacts DC. The term "connected to" may be used herein to refer to a physical and/or electrical connection. As used herein, when components or layers are referred to as "directly on" or "directly connected" or in "direct contact", no intervening components or layers are present. There may therefore be no intervening components or layers present between the bit lines BL and direct contacts DC, and/or between the direct contacts DC and active areas ACT. In some embodiments, a plurality of buried contacts BC (also referred to herein as buried contacts 170) may be formed between two adjacent bit lines BL of the plurality of bit lines BL. Each of the plurality of buried contacts BC may extend to an upper portion of any one of two bit lines BL adjacent to each other. In some embodiments, the plurality of buried contacts BC may be arranged in a line in the first horizontal direction (X direction) and the second horizontal direction (Y direction).

A plurality of landing pads LP (also referred to herein as landing pads 194) may be respectively formed on the plurality of buried contacts BC. The plurality of buried contacts BC and the plurality of landing pads LP may connect bottom electrodes of capacitors (not illustrated) formed on the plurality of bit lines BL respectively to the plurality of active areas ACT. The plurality of landing pads LP may respectively and partially overlap the plurality of buried contacts BC. Components or layers described with reference to "overlap" in a particular direction may be at least partially obstructed by one another when viewed along a line extending in the particular direction or in a plane perpendicular to the particular direction. Detailed descriptions thereof are given below.

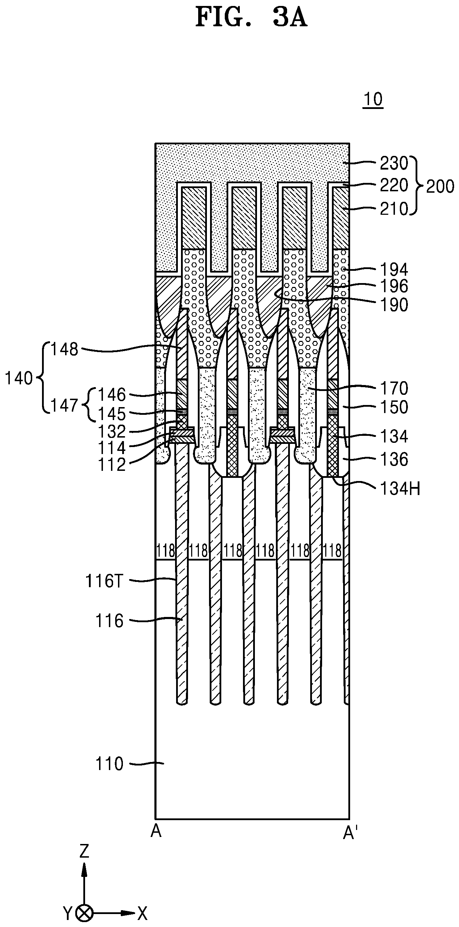

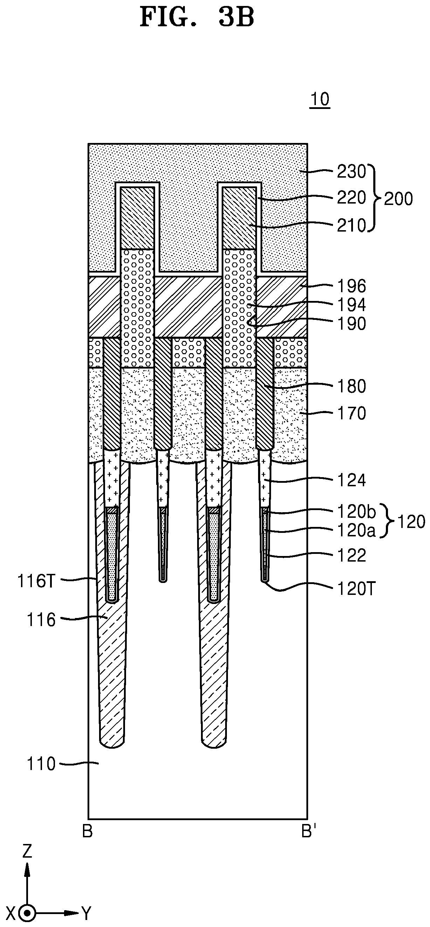

FIGS. 3A and 3B are cross-sectional views of main components of the integrated circuit device 10, according to embodiments.

FIG. 3A is a cross-sectional view taken along line A-A' in FIGS. 1 and 2, and FIG. 3B is a cross-sectional view taken along line B-B' in FIGS. 1 and 2.

Referring to FIGS. 3A and 3B together, the integrated circuit device 10 may include a plurality of memory cell structures formed on the substrate 110 including the cell area CA and the core/periphery area PA.

Main components constituting the integrated circuit device 10 according to the inventive concept are described below.

The integrated circuit device 10 may include a substrate 110 including a plurality of active areas 118, a plurality of gate dielectric layers 122 respectively and sequentially formed inside a plurality of word line trenches 120T crossing the plurality of active areas 118 in the substrate 110, a plurality of word lines 120, and a plurality of buried insulating layers 124.

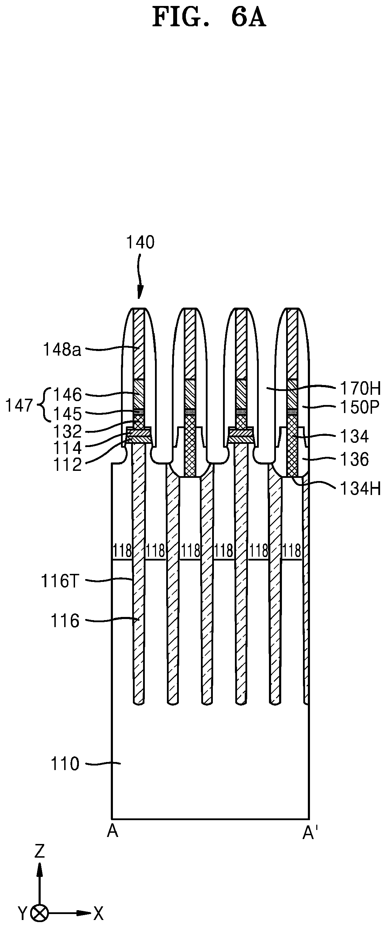

In addition, the integrated circuit device 10 may include a device separation layer 116, the plurality of active areas 118, first and second insulating layer patterns 112 and 114 on or covering the plurality of buried insulation layers 124, a plurality of bit line structures 140 (see FIGS. 6A-12A) on the first and second insulating layer patterns 112 and 114, and a plurality of insulating spacers 150 on or covering both (e.g., opposing) sidewalls of the plurality of bit line structures 140.

In addition, the integrated circuit device 10 may include a plurality of buried contacts 170 in or filling a lower portion of spaces defined by a plurality of insulating fences 180 and a plurality of insulating spacers 150 and connected to the plurality of active areas 118, and a plurality of landing pads 194 in or filling an upper portion of the spaces, extending to an upper side portion of the bit line structure 140 (refer to FIG. 3A) and apart from each other with a node separation pattern 196 therebetween. The term "fill" or "filling" as may be used herein is intended to refer to either completely or partially filling a defined space; that is, the defined space need not be entirely filled but may, for example, be partially filled or have voids or other spaces throughout.

In addition, the integrated circuit device 10 may include a plurality of capacitor structures 200 including a plurality of lower electrodes 210 connected to protrusions of the plurality of landing pads 194, a capacitor dielectric layer 220, and an upper electrode 230.

The integrated circuit device 10 of the inventive concept may have a shape in which the plurality of landing pads 194 protrude from an upper surface of the substrate 110. Because of the landing pad 194 having a protruding structure, an additional area of a capacitor electrode may be secured, and as a result, an improvement in capacitance of the capacitor electrode may be expected and/or achieved.

In the integrated circuit device 10 of the inventive concept, the node separation pattern 196 may contact one side surface of an insulation capping pattern 148 and contact an upper surface of the insulating spacer 150 arranged on the same side surface as the one side surface of the insulation capping pattern 148. In other words, a vertical level of a lowermost surface of the node separation pattern 196 may be lower than a vertical level of an uppermost surface of the insulating spacer 150. The node separation pattern 196 may be arranged, from an upper side thereof to a lower side thereof, to extend along a space between the landing pad 194 and a preliminary insulating spacer 150P. For example, the node separation pattern 196 may be rounded with a slope extending from the landing pad 194 toward the insulation capping pattern 148, which is an upper portion of the bit line structure 140.

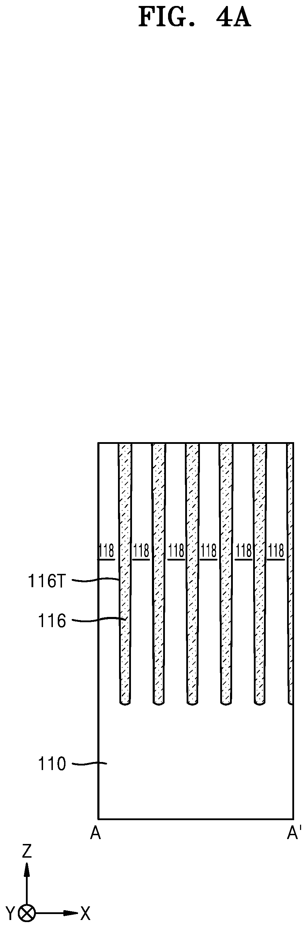

FIGS. 4A through 12A are cross-sectional views taken along positions corresponding to line A-A' in FIG. 2, and FIGS. 4B through 12B are cross-sectional views taken along positions corresponding to line B-B' in FIG. 2, which are cross-sectional views illustrating a manufacturing method of an integrated circuit device according to a process sequence, according to embodiments.

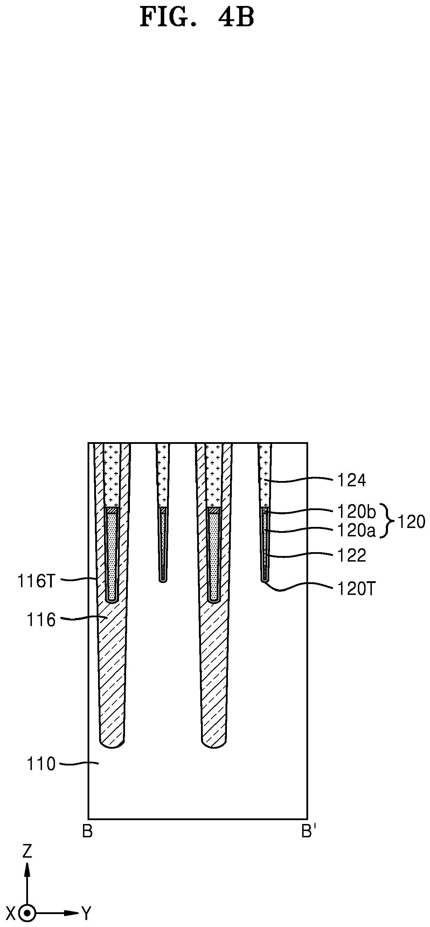

Referring to FIGS. 4A and 4B together, a device separation trench 116T may be formed in the substrate 110, and the device separation layer 116 filling the device separation trench 116T may be formed.

The device separation layer 116 (also referred to as an element separation area) may include a material including, for example, a silicon oxide layer, a silicon nitride layer, and/or a silicon oxynitride layer. The device separation layer 116 may include a single layer including one type of insulating layer, a double layer including two types of insulating layers, or a multiple layer including a combination of at least three types of insulating layers. For example, the device separation layer 116 may include a double layer or a multiple layer including a silicon oxide layer and a silicon nitride layer but is not limited thereto.

The plurality of active areas 118 may be defined by the device separation layer 116 in the substrate 110. The active area 118 may have a relatively long island or elongated shape having a short axis and a long axis in a plan view, like the active area ACT illustrated in FIG. 2.

The plurality of word line trenches 120T may be formed in the substrate 110. The plurality of word line trenches 120T may extend in parallel with each other in the first horizontal direction (X direction), and may have a line shape, in which each of the plurality of word line trenches 120T crosses the active area 118 and is arranged at an equal interval in the second horizontal direction (Y direction). In some embodiments, a step may be formed on a bottom surface of the plurality of word line trenches 120T.

In some embodiments, in forming the plurality of word line trenches 120T, the device separation layer 116 and the substrate 110 may be etched by using separate etching processes, so that an etching depth of the device separation layer 116 is different from an etching depth of the substrate 110. In some other embodiments, the plurality of word line trenches 120T may be etched together with the device separation layer 116 and the substrate 110, but due to a difference in etching rates of the device separation layer 116 and the substrate 110, the etching depth of the device separation layer 116 may be different from the etching depth of the substrate 110.

After cleaning a resultant product, in which the plurality of word line trenches 120T have been formed, the plurality of gate dielectric layers 122, the plurality of word lines 120, and the plurality of buried insulating layers 124 may be sequentially formed inside the plurality of word line trenches 120T. The plurality of word lines 120 may constitute the plurality of word lines WL illustrated in FIG. 2. The plurality of word lines 120 may extend in parallel with each other in the first horizontal direction (X direction), and may have a line shape, in which each of the plurality of word lines 120 crosses the active area 118 and is arranged at an equal interval in the second horizontal direction (Y direction). An upper surface of each of the plurality of word lines 120 may be at a lower level than the upper surface of the substrate 110. In addition, bottom surfaces of the plurality of word lines 120 may have an uneven shape, and transistors having a saddle fin structure (saddle FinFET) may be formed in the plurality of active areas 118.

In some embodiments, each of the plurality of word lines 120 may have a stacked structure including a lower word line layer 120a and an upper word line layer 120b. For example, the lower word line layer 120a may include a metal material, conductive metal nitride, or a combination thereof. In some embodiments, the lower word line layer 120a may include Ti, TiN, Ta, TaN, W, WN, TiSiN, WSiN, or a combination thereof. For example, the upper word line layer 120b may include doped polysilicon.

In some embodiments, before or after forming the plurality of word lines 120, impurity ions may be injected into the active area 118 on both or opposing sides of the plurality of word lines 120 to form a source/drain area inside the substrate 110.

The gate dielectric layer 122 may include a silicon oxide layer, a silicon nitride layer, a silicon oxynitride layer, an oxide/nitride/oxide (ONO) layer, and/or a high-k dielectric layer having a higher dielectric constant than the silicon oxide layer. In some embodiments, the gate dielectric layer 122 may include hafnium oxide (HfO), hafnium silicate (HfSiO), hafnium oxynitride (HfON), hafnium silicon oxynitride (HfSiON), or lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), strontium titanium oxide (SrTiO), yttrium oxide (YO), aluminum oxide (AlO), and/or lead scandium tantalum oxide (PbScTaO). For example, the gate dielectric layer 122 may include HfO₂, Al₂O₃, HfAlO₃, Ta₂O₃, and/or TiO₂.

Upper surfaces of the plurality of buried insulating layers 124 may be at substantially the same vertical level or height (e.g., along the Z direction) as the upper surface of the substrate 110. The buried insulating layer 124 may include a silicon oxide layer, a silicon nitride layer, a silicon oxynitride layer, or a combination thereof.

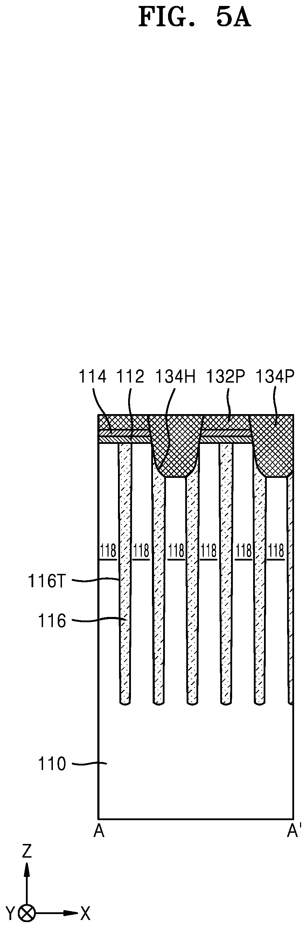

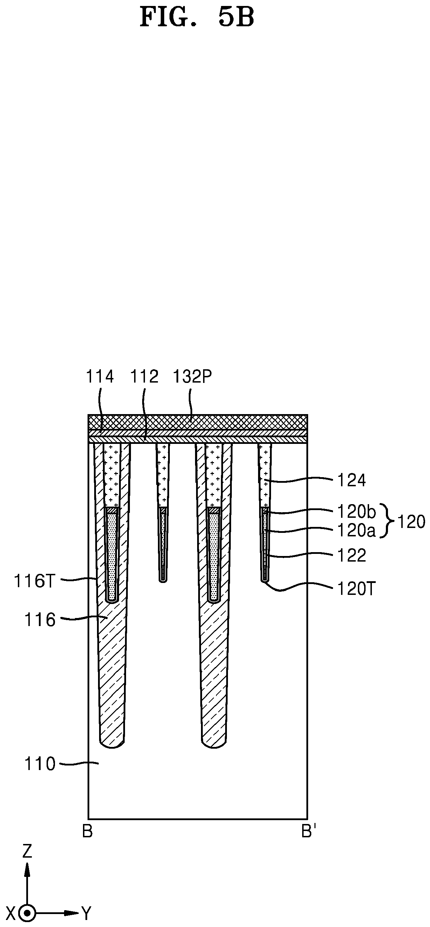

Referring to FIGS. 5A and 5B together, the first and second insulating layer patterns 112 and 114 on or covering the device separation layer 116, the plurality of active areas 118, and the plurality of buried insulating layers 124 may be formed.

The first and second insulating layer patterns 112 and 114 may include, for example, a silicon oxide layer, a silicon nitride layer, a silicon oxynitride layer, or a combination thereof In some embodiments, the first and second insulating layer patterns 112 and 114 may be formed by stacking a plurality of insulating layers including the first insulating layer pattern 112 and the second insulating layer pattern 114. In some embodiments, the first insulating layer pattern 112 may include a silicon oxide layer, and the second insulating layer pattern 114 may include a silicon nitride layer. In other embodiments, the first insulating layer pattern 112 may include a non-metal dielectric layer, and the second insulating layer pattern 114 may include a metal dielectric layer.

After a conductive semiconductor layer 132P is formed on the first and second insulating layer patterns 112 and 114, a direct contact hole 134H penetrating the conductive semiconductor layer 132P and the first and second insulating layer patterns 112 and 114 and exposing the source/drain area in the active area 118 may be formed, and a direct contact-purpose conductive layer 134P filling the direct contact hole 134H may be formed. The direct contact hole 134H may extend from the active area 118 to the inside of the source/drain area.

The conductive semiconductor layer 132P may include, for example, doped polysilicon. The direct contact-purpose conductive layer 134P may include, for example, doped polysilicon, tungsten (W), tungsten nitride (WN), cobalt (Co), nickel (Ni), aluminum (Al), molybdenum (Mo), ruthenium (Ru), titanium nitride (TiN), tantalum (Ta), tantalum nitride (TaN), copper (Cu), or a combination thereof.

In other embodiments, after the direct contact hole 134H penetrating the first and second insulating layer patterns 112 and 114 and exposing the source/drain area in the active area 118 is formed, the conductive semiconductor layer 132P filling the direct contact hole 134H in the first and second insulating layer patterns 112 and 114 may also be formed together with the direct contact-purpose conductive layer 134P.

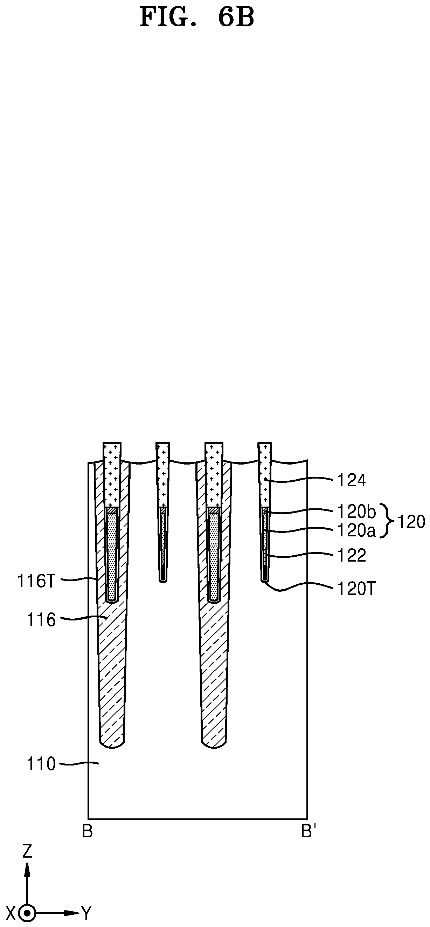

Referring to FIGS. 6A and 6B together, a metal-based conductive layer and a first insulation capping layer for respectively covering the conductive semiconductor layer 132P and the direct contact-purpose conductive layer 134P, and for forming the bit line structure 140 may be sequentially formed.

In some embodiments, the metal-based conductive layer may have a stacked structure including a first metal-based conductive layer and a second metal-based conductive layer. The metal-based conductive layer may have a conductive layer stacked structure of a double layer structure, but is not limited thereto. For example, the metal-based conductive layer may have a plurality of stacked structures of a single layer or three or more layers.

By etching the first metal-based conductive layer, the second metal-based conductive layer, and the insulation capping layer, a plurality of bit lines 147 including a first metal-based pattern 145 and a second metal-based pattern 146 in a line shape, and a plurality of first insulation capping patterns 148a may be formed.

In some embodiments, the first metal-based pattern 145 may include titanium nitride (TiN) or Ti-Si-N (TSN), and the second metal-based pattern 146 may include W or tungsten silicide (WSiₓ).

The plurality of first insulation capping patterns 148a may be formed to be thick, e.g., to a predetermined or desired thickness.

In some embodiments, the plurality of first insulation capping patterns 148a may include a silicon-based insulating layer. For example, the first insulation capping pattern 148a may include a silicon nitride layer.

One bit line 147 and one or more first insulation capping patterns 148a on or covering the one bit line 147 may constitute one bit line structure 140. Each of the plurality of bit line structures 140 including the plurality of bit lines 147 and the plurality of first insulation capping patterns 148a may extend in parallel with each other and extend with respect to a main surface of the substrate 110 in the second horizontal direction (Y direction). The plurality of bit lines 147 may constitute the plurality of bit lines BL illustrated in FIG. 2. In some embodiments, the bit line structure 140 may further include a conductive semiconductor layer (refer to 132P in FIG. 5A) arranged between the first and second insulating layer patterns 112 and 114 and the first metal-based pattern 145.

In an etching process for forming the plurality of bit lines 147, by removing a portion of the direct contact-purpose conductive layer (refer to 134P in FIG. 5A), which does not vertically overlap the bit line 147, by using an etching process, a plurality of direct contact patterns 134 may be formed. In this case, the first and second insulating layer patterns 112 and 114 may function as etching stop layers in an etching process of forming the plurality of bit lines 147 and the plurality of direct contact patterns 134. The plurality of direct contact patterns 134 may constitute the plurality of direct contacts DC illustrated in FIG. 2. The plurality of bit lines 147 may be electrically connected to the plurality of active areas 118 via the plurality of direct contact patterns 134, respectively.

After the bit line structure 140 is formed, in the process of forming the direct contact pattern 134, a buried insulating pattern 136 may be formed to fill a portion of the direct contact hole 134H, from which a portion of the direct contact conductive layer (refer to 134P in FIG. 5A) has been removed. The buried insulating pattern 136 may include, for example, a silicon nitride layer.

Both (e.g., opposing) sidewalls of each of the plurality of bit line structures 140 may be covered by the preliminary insulating spacer 150P. In some embodiments, each of the plurality of preliminary insulating spacers 150P may have a stacked structure including a first preliminary insulating spacer and a second preliminary insulating spacer. The plurality of preliminary insulating spacers 150P may have a stacked structure of double layers, but is not limited thereto. For example, the plurality of preliminary insulating spacers may have a plurality of stacked structures of a single layer or three or more layers.

A plurality of buried contact holes 170H may be formed between the plurality of bit lines 147. Inner spaces of the plurality of buried contact holes 170H may be defined by the preliminary insulating spacer 150P, which covers the sidewalls of each of two adjacent bit lines 147 between the two adjacent bit lines of the plurality of bit lines 147, and the active area 118.

The plurality of buried contact holes 170H may be formed by removing portions of the first and second insulating layer patterns 112 and 114 and the active area 118, by using a plurality of insulation capping patterns 148 and the preliminary insulating spacer 150P as etching masks. In some embodiments, by first performing an anisotropic etching process of removing portions of the first and second insulating layer patterns 112 and 114 and a portion of the active area 118, and by further performing an anisotropic etching process of removing another or additional portion of the active area 118, the plurality of buried contact holes 170H may be formed so that a space thereof defined by the active area 118 is expanded.

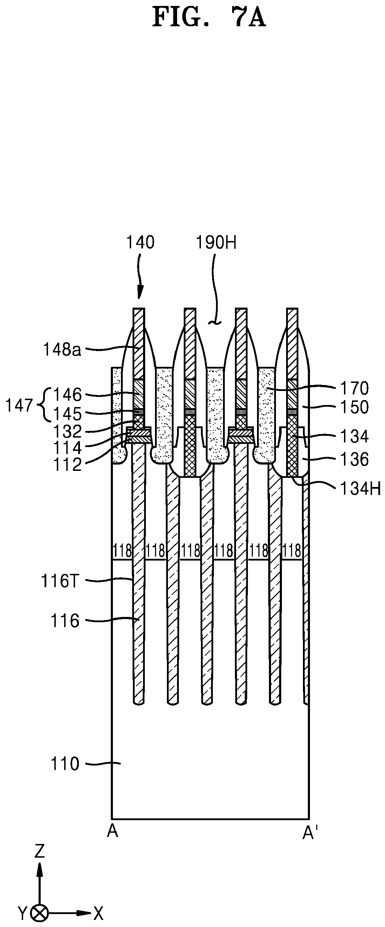

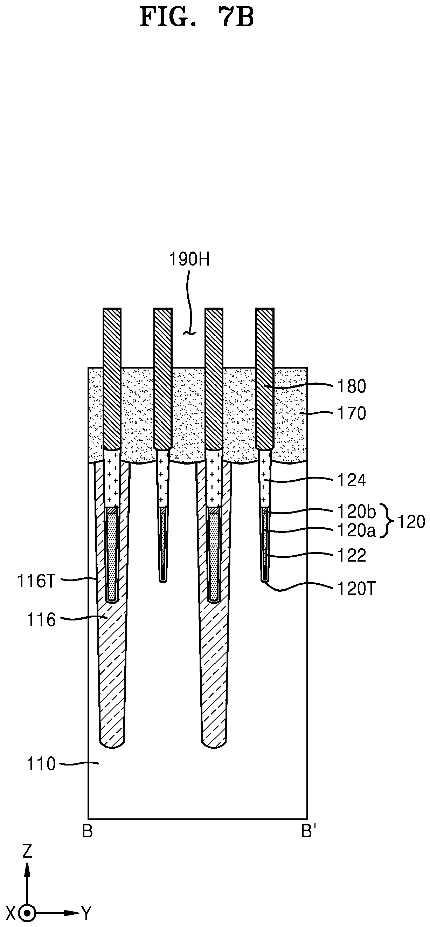

Referring to FIGS. 7A and 7B together, the plurality of buried contacts 170 and the plurality of insulating fences 180 may be formed in spaces between the plurality of preliminary insulating spacers (refer to 150P in FIG. 6A) on or covering both (e.g., opposing) sidewalls of each of the plurality of bit line structures 140, and the insulating spacer 150 may be formed by etching an upper portion of the preliminary insulating spacer (refer to 150P in FIG. 6A).

The plurality of buried contacts 170 and the plurality of insulating fences 180 may be alternately arranged, along a pair of preliminary insulating spacers (refer to 150P in FIG. 6A) facing each other among the plurality of preliminary insulating spacers (refer to 150P in FIG. 6A) covering the sidewalls of the plurality of bit line structures 140. For example, the plurality of buried contacts 170 may include doped polysilicon, and the plurality of insulating fences 180 may include a silicon nitride layer.

The plurality of buried contacts 170 may extend from the active area 118 in a vertical direction (Z direction) perpendicular to the substrate 110. The plurality of buried contacts 170 may constitute the plurality of buried contacts BC illustrated in FIG. 2. The plurality of buried contacts 170 may be arranged in spaces defined by the plurality of insulating fences 180 and the plurality of preliminary insulating spacers (refer to 150P in FIG. 6A). In addition, the plurality of buried contacts 170 may fill a portion of a lower side of spaces between the plurality of preliminary insulating spacers (refer to 150P in FIG. 6A).

The upper surface of the plurality of buried contacts 170 may be at a lower vertical level or height than an upper surface of the plurality of first insulation capping patterns 148a, relative to the substrate 110. In addition, the upper surface of the plurality of insulating fences 180 and the upper surface of the plurality of first insulation capping patterns 148a may be at substantially the same vertical level.

The plurality of landing pad holes 190H may be defined by the plurality of preliminary insulating spacers (refer to 150P in FIG. 7A) and the plurality of insulating fences 180. The plurality of buried contacts 170 may be exposed at the bottom surfaces of the plurality of landing pad holes 190H. The term "exposed" may be used to describe relationships between elements and/or intermediate processes in fabricating a completed semiconductor device.

In a process of forming the plurality of buried contacts 170 and/or the plurality of insulating fences 180, the insulating spacer 150 may be formed by removing a portion of the upper side of the preliminary insulating spacer (refer to 150P in FIG. 6A), and portions of the upper surface and the side surfaces of the first insulation capping pattern 148a may be exposed to the outside. Alternatively, by etching the upper portion of the preliminary insulating spacer (refer to 150P in FIG. 6A) by using an additional etching process so that the upper portion of the first insulation capping pattern 148a is exposed, the insulating spacer 150 may be formed.

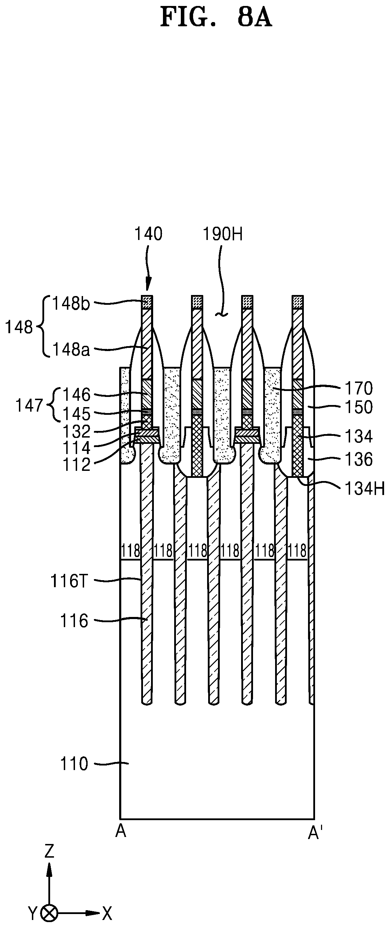

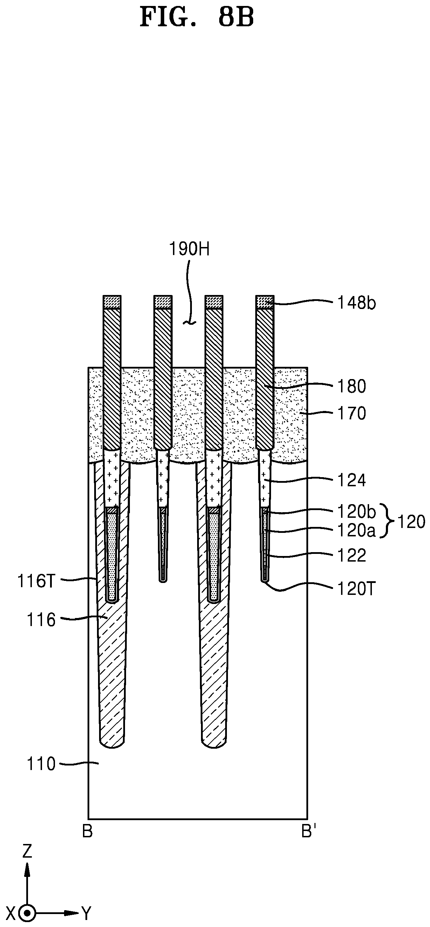

Referring to FIGS. 8A and 8B together, a second insulation capping pattern 148b conformally covering the first insulation capping pattern 148a may be formed along the plurality of landing pad holes 190H.

For example, the second insulation capping pattern 148b may include tetra-ethyl-ortho-silicate (TEOS). In some embodiments, the second insulation capping pattern 148b may have a thickness of 300 Å to 1500 Å. For example, the thickness of the second insulation capping pattern 148b may correspond to 500 Å.

In some embodiments, the second insulation capping pattern 148b may be deposited onto the first insulation capping pattern 148a at a conformal thickness. In some embodiments, the surface or interface, which is a boundary between the second insulation capping pattern 148b and the first insulation capping pattern 148a, may have a flat surface (i.e., may be substantially planar) in a direction in parallel with the substrate 110.

As the second insulation capping pattern 148b is additionally formed, the capacitor according to the inventive concept may include a protruding landing pad that is at least as thick as the second insulation capping pattern 148b, which has been additionally deposited, and as a result, the capacitor capacitance may be improved.

In some embodiments, after the second insulation capping pattern 148b is formed, a barrier conductive layer (not illustrated) may be formed. For example, the barrier conductive layer may include a metal, conductive metal nitride, or a combination thereof. In some embodiments, the barrier conductive layer may have a Ti/TiN stacked structure or a TiN stacked structure. The barrier conductive layer may extend on or cover both the upper portion of the insulation capping pattern 148 and the upper portion of the insulating spacer 150. In addition, the barrier conductive layer may cover both an upper surface of the buried contact 170 and an upper portion of the insulating fence 180.

In some embodiments, when the barrier conductive layer is formed, a metal silicide layer may be formed on the plurality of buried contacts 170 before the barrier conductive layer is formed. The metal silicide layer may be arranged between the plurality of buried contacts 170 and the barrier conductive layer. The metal silicide layer may include cobalt silicide (CoSiₓ), nickel silicide (NiSiₓ), or manganese silicide (MnSiₓ), but is not limited thereto.

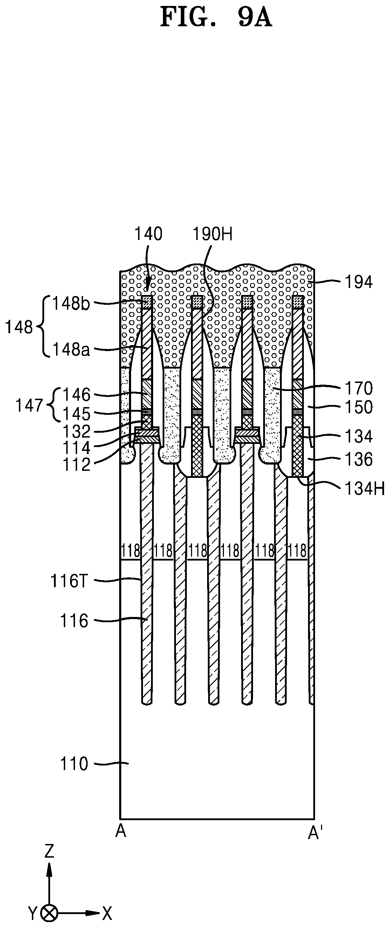

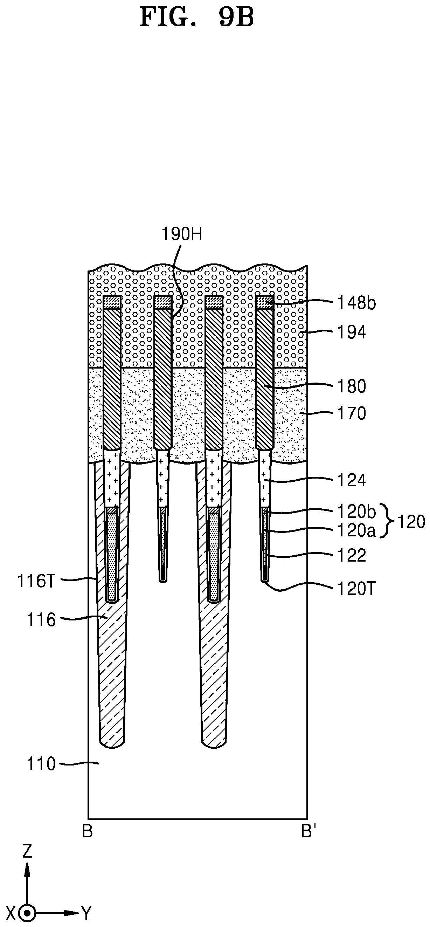

Referring to FIGS. 9A and 9B together, a landing pad layer 194 may be formed to fill the plurality of landing pad holes 190H and cover the barrier conductive layer (not illustrated).

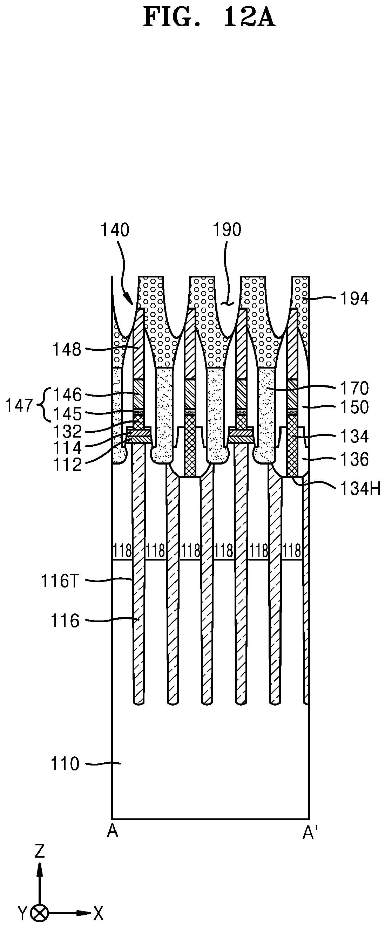

The landing pad layer 194 may include W. In some embodiments, because the landing pad layer 194 is formed by filling the plurality of landing pad holes 190H, lower and upper surfaces of the landing pad layer 194 may have uneven surfaces. In some embodiments, the landing pad layer 194 may constitute a lower area of the landing pad (refer to 194 in FIG. 12A).

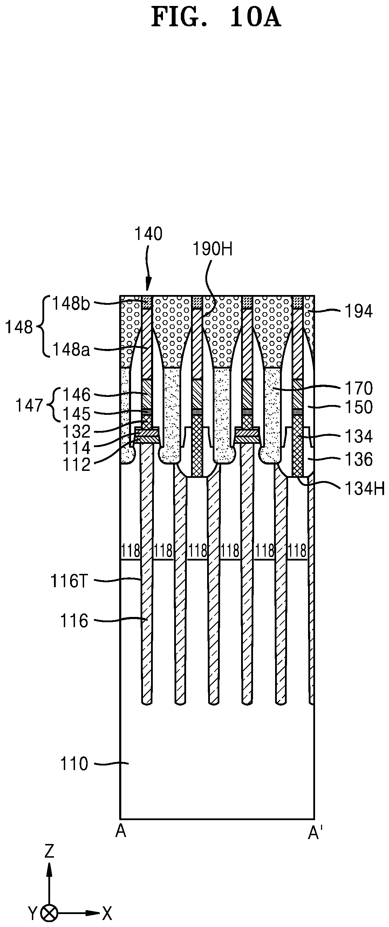

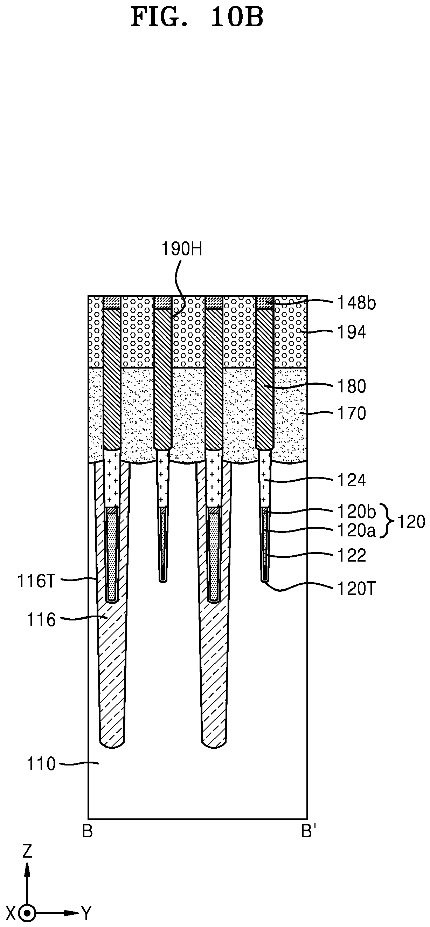

Referring to FIGS. 10A and 10B together, the landing pad layer 194 may be abraded so that an upper surface of the insulation capping pattern 148 is exposed. The landing pad layer 194 may be abraded to a height at which the uppermost surface of the second insulation capping pattern 148b is exposed.

Abrasion and planarization processes may be performed by using a grinder. The abrasion and planarization processes may include a chemical mechanical abrasion process. The grinder may remove a portion of the landing pad layer 194 by abrasion and planarization processes, and form a flat or substantially planar surface to which the uppermost surfaces of the plurality of insulation capping patterns 148 are exposed.

After the abrasion and planarization processes are completed, the second insulation capping pattern 148b, which is the uppermost surface of the insulation capping pattern 148, may be coplanar with the uppermost surface of the landing pad layer 194.

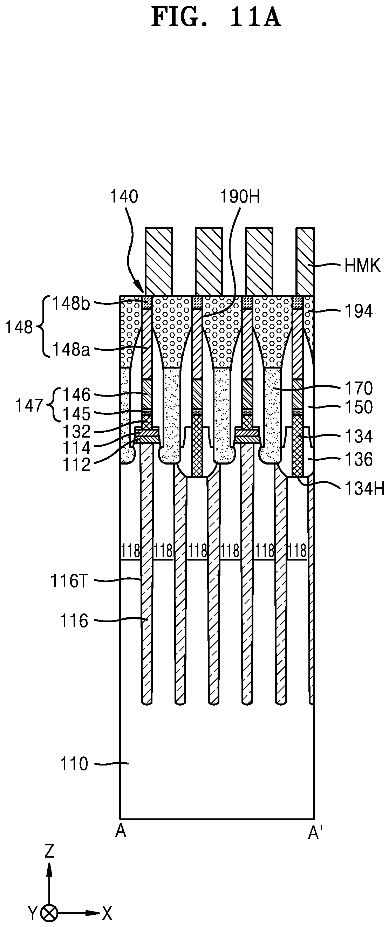

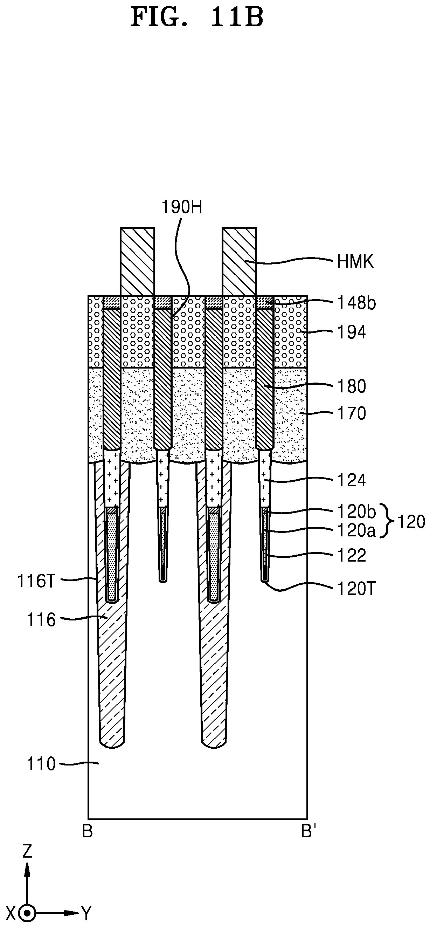

Referring to FIGS. 11A and 11B together, a plurality of hard mask patterns HMK may be formed on the upper surface of the plurality of insulation capping patterns 148 and the upper surface of the landing pad layer 194, on which the abrasion process has been completed. In some embodiments, the plurality of hard mask patterns HMK may be formed by using an argon fluoride (ArF) lithography process or an extreme ultraviolet (EUV) lithography process.

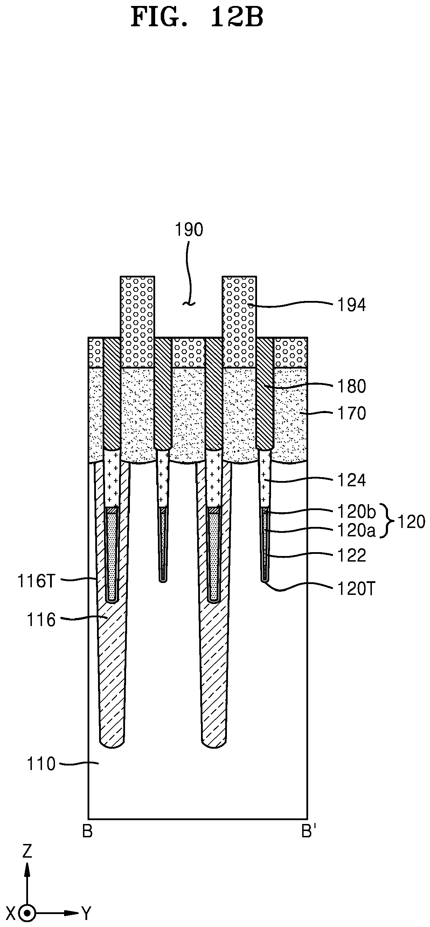

Referring to FIGS. 12A and 12B together, a recess 190 may be formed by performing an etching process of removing a portion of the landing pad layer 194 by using the plurality of hard mask patterns (refer to HMK in FIG. 11A) as an etching mask.

In the etching process of forming the recess 190, a portion of an upper side of the plurality of insulating spacers 150, a portion of an upper side of the plurality of insulation capping patterns 148, and a portion of an upper side of the plurality of insulating fences 180 may be removed.

The landing pad layer 194 may constitute the plurality of landing pads 194 by using a process of separating the landing pad layer 194 by using the recess 190, which is generally referred to as a node separation process. The plurality of landing pads 194 may be spaced apart from each other with the recess 190 therebetween.

The plurality of landing pads 194 may be respectively arranged on the plurality of buried contacts 170, and may respectively extend onto the plurality of bit line structures 140. In some embodiments, the plurality of landing pads 194 may respectively extend onto the plurality of bit lines 147. The plurality of landing pads 194 may be respectively arranged on the plurality of buried contacts 170, and the plurality of buried contacts 170 may be electrically connected to the plurality of landing pads 194 corresponding thereto. The plurality of landing pads 194 may be electrically connected to the active area 118 via the plurality of buried contacts 170, respectively.

The plurality of landing pads 194 may respectively constitute the plurality of landing pads LP illustrated in FIG. 2. In some embodiments, the plurality of landing pads 194 may include W.

The buried contact 170 may be arranged between two bit line structures 140 adjacent to each other, and the landing pad 194 may extend, from a space between two adjacent bit line structures 140 with the buried contact 170 therebetween, onto one bit line structure 140.

Referring to FIGS. 3A and 3B together again, after the node separation pattern 196 filling the recess 190 is formed, the plurality of lower electrodes 210, the capacitor dielectric layer 220, and the upper electrode 230 may be sequentially formed on the plurality of landing pads 194 to form the integrated circuit device 10 including the plurality of capacitor structures 200.

In some embodiments, the node separation pattern 196 may include an interlayer insulating layer and an etch stop layer. For example, the interlayer insulating layer may include a silicon oxide layer, and the etch stop layer may include a silicon nitride layer.

The plurality of lower electrodes 210 may be respectively on and electrically connected to the plurality of landing pads 194. The capacitor dielectric layer 220 may conformally cover the plurality of lower electrodes 210. The upper electrode 230 may cover the capacitor dielectric layer 220. The upper electrode 230 may face the lower electrode 210 with the capacitor dielectric layer 220 therebetween. Each of the capacitor dielectric layer 220 and the upper electrode 230 may be formed in one body (e.g. as an integrated or continuous layer) to cover the plurality of lower electrodes 210 together, in a certain area.

In some embodiments, each of the plurality of lower electrodes 210 may have a pillar shape, in which the inside thereof is filled to have a circular horizontal cross-section, but is not limited thereto. In other embodiments, each of the plurality of lower electrodes 210 may have a cylinder shape having a closed lower portion thereof. In addition, the plurality of lower electrodes 210 may be arranged in a honeycomb shape arranged in a zigzag manner with respect to the first horizontal direction (X direction) or the second horizontal direction (Y direction). Alternatively, the plurality of lower electrodes 210 may be arranged in a matrix form, in which the plurality of lower electrodes 210 are arranged in a line in each of the first horizontal direction (X direction) and the second horizontal direction (Y direction). The plurality of lower electrodes 210 may include, for example, silicon doped with impurities, a metal, such as tungsten and copper, or a conductive metal compound such as titanium nitride. Although not illustrated, at least one support pattern in contact with sidewalls of the plurality of lower electrodes 210 may be further included.

The capacitor dielectric layer 220 may include, for example, TaO, TaAlO, TaON, AlO, AlSiO, HfO, HfSiO, ZrO, ZrSiO, TiO, TiAlO, (Ba,Sr)TiO (BST), SrTiO (STO), BaTiO (BTO), Pb(Zr,Ti)O (PZT), (Pb,La)(Zr,Ti)O, Ba(Zr,Ti)O, Sr(Zr,Ti)O, or a combination thereof.

The upper electrode 230 may include, for example, doped silicon, Ru, RuO, Pt, PtO, Ir, IrO, SrRuO (SRO), (Ba,Sr)RuO (BSRO), CaRuO (CRO), BaRuO, La(Sr,Co)O, Ti, TiN, W, WN, Ta, TaN, TiAlN, TiSiN, TaAlN, TaSiN, or a combination thereof.

By using the example manufacturing method described above, the integrated circuit device 10 according to the inventive concept may be manufactured. The integrated circuit device 10 according to the inventive concept may have the landing pad LP, which protrudes, by thickly depositing a material of the landing pad LP in the manufacturing process of the landing pad LP, and separating a node of a double layer including the first insulation capping pattern 148a and the second insulation capping pattern 148b. As a result, an area (e.g., a surface area) of the capacitor electrode may be additionally secured without increasing the difficulty in the etching process of the capacitor, and the capacitance of the capacitor may be improved or increased, for example, by as much as the secured or additional electrode area.

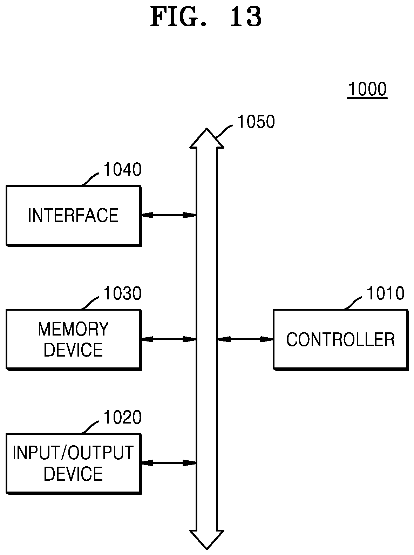

FIG. 13 is a configuration diagram of a system 1000 including an integrated circuit device, according to an embodiment.

Referring to FIG. 13, the system 1000 may include a controller 1010, an input/output device 1020, a memory device 1030, an interface 1040, and a bus 1050.

The system 1000 may include a mobile system or a system for transceiving information. In some embodiments, the mobile system may include a portable computer, a web tablet, a mobile phone, a digital music player, or a memory card.

The controller 1010 may be used for controlling execution programs in the system 1000, and may include a micro-processor, a digital signal processor, a micro-controller, or a similar device.

The input/output device 1020 may be used to input or output data of the system 1000. The system 1000 may be connected to an external device, for example, a personal computer or a network by using the input/output device 1020, and may exchange data with the external device. The input/output device 1020 may include, for example, a touch screen, a touch pad, a keyboard, or a display.

The memory device 1030 may store data for an operation of the controller 1010, or may store data processed by the controller 1010. The memory device 1030 may include the integrated circuit device 10 according to the inventive concept described above.

The interface 1040 may include a data transmission path between the system 1000 and an external device. The controller 1010, the input/output device 1020, the memory device 1030, and the interface 1040 may communicate with each other via the bus 1050.

While the inventive concept has been particularly shown and described with reference to embodiments thereof, it will be understood that various changes in form and details may be made therein without departing from the scope of the following claims.

The invention may alternatively be defined by any one of the following numbered clauses.
1. An integrated circuit device comprising:
   a substrate having an active area;
   a plurality of bit line structures on the substrate, wherein a bit line structure of the plurality of bit line structures includes an insulating spacer on a sidewall thereof;
   a buried contact between the plurality of bit line structures, and electrically connected to the active area;
   an insulation capping pattern on the bit line structure; and
   a landing pad electrically connected to the buried contact, the landing pad arranged to vertically overlap the bit line structure on the insulation capping pattern,
   wherein an uppermost surface of the landing pad is higher than an uppermost surface of the insulation capping pattern relative to the substrate.
2. The integrated circuit device of clause 1, wherein the uppermost surface of the landing pad is higher than the uppermost surface of the insulation capping pattern by about 300 Å to 1500 Å, relative to the substrate.
3. The integrated circuit device of clause 1 or 2, wherein the insulation capping pattern comprises a first layer including silicon nitride, and a second layer including tetra-ethyl-ortho-silicate (TEOS).
4. The integrated circuit device of clause 3, wherein a thickness of the second layer is substantially identical to a height difference between the uppermost surface of the landing pad and the uppermost surface of the insulation capping pattern, along a direction perpendicular to the substrate.
5. The integrated circuit device of clause 3 or 4, wherein an interface between the first layer and the second layer is substantially planar in a direction in parallel with the substrate.
6. The integrated circuit device of any preceding clause, wherein the insulating spacer extends on a side surface of the insulation capping pattern, and further comprising:
   a node separation pattern contacting the side surface of the insulation capping pattern and contacting an upper surface of the insulating spacer on the side surface of the insulation capping pattern.
7. The integrated circuit device of clause 6, wherein the node separation pattern contacts the landing pad.
8. The integrated circuit device of any preceding clause, wherein the insulation capping pattern comprises an epitaxial layer.
9. An integrated circuit device comprising:
   a substrate including a cell area and a peripheral area;
   a plurality of bit line structures on the cell area, wherein a bit line structure of the plurality of bit line structures includes an insulating spacer on a sidewall thereof;
   a buried contact between the plurality of bit line structures;
   an insulation capping pattern on the bit line structure;
   a landing pad electrically connected to the buried contact, the landing pad arranged to vertically overlap the bit line structure on the insulation capping pattern; and
   a core structure on the peripheral area, and including a barrier metal layer on sidewalls thereof,
   wherein an uppermost surface of the core structure is substantially coplanar with an uppermost surface of the landing pad, and
   wherein the uppermost surface of the landing pad is higher than an uppermost surface of the insulation capping pattern relative to the substrate.
10. The integrated circuit device of clause 9, wherein, on an interface surface between the cell area and the peripheral area, the uppermost surface of the insulation capping pattern is substantially coplanar with the uppermost surface of the core structure.
11. The integrated circuit device of clause 9 or 10, wherein, on the cell area, the uppermost surface of the landing pad is substantially coplanar with an uppermost surface of a conductive material layer comprising a same material as the landing pad on the peripheral area.
12. The integrated circuit device of clause 9, 10 or 11, wherein the uppermost surface of the landing pad is higher than the uppermost surface of the insulation capping pattern by about 300 Å to 1500 Å, relative to the substrate.
13. The integrated circuit device of any one of clauses 9 to 12, wherein the insulation capping pattern comprises a first layer including silicon nitride, and a second layer including tetra-ethyl-ortho-silicate (TEOS),
   wherein a thickness of the second layer is substantially identical to a height difference between the uppermost surface of the landing pad and the uppermost surface of the insulation capping pattern, along a direction perpendicular to the substrate.
14. The integrated circuit device of any one of clauses 9 to 13, wherein the landing pad does not directly contact the insulating spacer.
15. The integrated circuit device of any one of clauses 9 to 14, wherein the cell area comprises an active area defined by an element separation area, and the buried contact is electrically connected to the active area.

## Claims

1. An integrated circuit device comprising:
a substrate (110) having an active area (118);
a plurality of bit line structures (140) on the substrate, wherein a bit line structure (140) of the plurality of bit line structures (140) includes an insulating spacer (150) on a sidewall thereof;
a buried contact (170) between the plurality of bit line structures (140), and electrically connected to the active area (118);
an insulation capping pattern (148) on the bit line structure (140); and
a landing pad (194) electrically connected to the buried contact (170), the landing pad (194) arranged to vertically overlap the insulation capping pattern (148),
wherein an uppermost surface of the landing pad (194) is higher than an uppermost surface of the insulation capping pattern (148) relative to the substrate (110).

2. The integrated circuit device of claim 1, wherein the uppermost surface of the landing pad is higher than the uppermost surface of the insulation capping pattern by about 300 Å to 1500 Å, relative to the substrate.

3. The integrated circuit device of claim 1 or 2, wherein the insulation capping pattern comprises a first layer including silicon nitride, and a second layer including tetra-ethyl-ortho-silicate (TEOS).

4. The integrated circuit device of claim 3, wherein a thickness of the second layer is substantially identical to a height difference between the uppermost surface of the landing pad and the uppermost surface of the insulation capping pattern, along a direction perpendicular to the substrate.

5. The integrated circuit device of claim 3 or 4, wherein an interface between the first layer and the second layer is substantially planar in a direction in parallel with the substrate.

6. The integrated circuit device of any preceding claim, wherein the insulating spacer extends on a side surface of the insulation capping pattern, and further comprising:
a node separation pattern contacting the side surface of the insulation capping pattern and contacting an upper surface of the insulating spacer on the side surface of the insulation capping pattern.

7. The integrated circuit device of claim 6, wherein the node separation pattern contacts the landing pad.

8. The integrated circuit device of any preceding claim, wherein the insulation capping pattern comprises an epitaxial layer.

9. An integrated circuit device as claimed in any preceding claim, wherein:
said substrate includes a cell area and a peripheral area;
the integrated circuit device further comprises a core structure on the peripheral area, and including a barrier metal layer on sidewalls thereof, and
wherein an uppermost surface of the core structure is substantially coplanar with an uppermost surface of the landing pad, and
wherein the uppermost surface of the landing pad is higher than an uppermost surface of the insulation capping pattern relative to the substrate.

10. The integrated circuit device of claim 9, wherein, on an interface surface between the cell area and the peripheral area, the uppermost surface of the insulation capping pattern is substantially coplanar with the uppermost surface of the core structure.

11. The integrated circuit device of claim 9 or 10, wherein, on the cell area, the uppermost surface of the landing pad is substantially coplanar with an uppermost surface of a conductive material layer comprising a same material as the landing pad on the peripheral area.

12. The integrated circuit device of claim 9, 10 or 11, wherein the uppermost surface of the landing pad is higher than the uppermost surface of the insulation capping pattern by about 300 Å to 1500 Å, relative to the substrate.

13. The integrated circuit device of any one of claims 9 to 12, wherein the insulation capping pattern comprises a first layer including silicon nitride, and a second layer including tetra-ethyl-ortho-silicate (TEOS),
wherein a thickness of the second layer is substantially identical to a height difference between the uppermost surface of the landing pad and the uppermost surface of the insulation capping pattern, along a direction perpendicular to the substrate.

14. The integrated circuit device of any one of claims 9 to 13, wherein the landing pad does not directly contact the insulating spacer.

15. The integrated circuit device of any one of claims 9 to 14, wherein the cell area comprises an active area defined by an element separation area, and the buried contact is electrically connected to the active area.
